# EUROPEAN PATENT SPECIFICATION

(11) **EP 3 411 749 B1**
(45) Date of publication and mention of the grant of the patent: **11.05.2022**
(21) Application number: 16838050.9
(22) Date of filing: 01.07.2016
(51) Int. Cl.: G02F 1/133, G02F 1/1333, G02F 1/1335

(54) **DISPLAY PANEL, AND DISPLAY APPARATUS**
ANZEIGETAFEL UND ANZEIGEVORRICHTUNG
PANNEAU D'AFFICHAGE, ET APPAREIL D'AFFICHAGE

(30) Priority: 02.02.2016 CN 201610074558
(43) Date of publication of application: 12.12.2018
(73) Proprietor: BOE Technology Group Co., Ltd., Beijing 100015 (CN); Chengdu BOE Optoelectronics Technology Co., Ltd., Hi-tech Development Zone Chengdu Sichuan 611731 (CN)
(72) Inventor: ZANG, Pengcheng, Beijing 100176 (CN); WANG, Yang, Beijing 100176 (CN); LI, Ting, Beijing 100176 (CN)
(74) Representative: Cohausz & Florack
(86) International application number: PCT/CN2016/088172
(87) International publication number: WO 2017/133180

(56) References cited:
- CN-A- 101 782 697
- CN-A- 101 782 697
- CN-A- 101 849 255
- CN-A- 105 206 213
- CN-A- 105 511 152
- CN-A- 105 911 744
- CN-U- 205 334 901
- US-A1- 2006 077 191
- US-A1- 2010 214 195
- US-A1- 2010 289 994

## Description

### CROSS-REFERENCE TO RELATED APPLICATION

The present application claims priority to Chinese Patent Application No. 201610074558.3 filed on February 2, 2016.

### TECHNICAL FIELD

This disclosure relates generally to the field of display technology, and more specifically to a special-shaped display panel, and a display apparatus.

### BACKGROUND

With the rapid development of display technologies, there has been an increasingly high demands for display panels to adapt to different surroundings, which has prompted the emergence of display panels with specialty designs. These display panels can have non-rectangular shapes, such as circular, semicircular, octagon, or other desired shapes. Some of the specialty display panels can be modified on the basis of conventional rectangular display panels, and configured to better adapt to the overall structure and environment of the buildings in which they are disposed. Currently, common display panels with special shapes may include fan-shaped, curved, circular, cylindrical, and triangular shaped display panels.

US patent application US 2010/214195 A1 discloses an irregularly-shaped display panel having a display region with a contour section having a good appearance, which is easily designed and produced. The a display panel comprises a display region including: an array of a plurality of pixels each constituted by a plurality of sub-pixels; and a plurality of wirings provided along boundaries of the plurality of sub-pixels, wherein a plurality of pixels include a pixel for a contour located in a contour section of the display region; the sub-pixels constituting the pixel for a contour have aperture regions having similar aperture areas to one another and contour lines each running in parallel with a drawing direction of one of the wirings at least on the side of a frame region; and the aperture area of the pixel for a contour is smaller than an aperture area of a pixel located at an inner side of the contour section of the display region.

US patent application US 2010/289994 A1 discloses a color image display device including an end portion unit pixel formed in an edge portion of a display region in which a color image is displayed and including end portion sub-pixels which correspond to a plurality of kinds of primary colors respectively in a one-to-one relationship and an inner unit pixel formed in an inside of the display region with respect to the end portion unit pixels and including inner sub-pixels which correspond to the plurality of kinds of primary colors respectively in a one-to-one relationship.

Chinese patent application CN 101 782 697 A discloses a color filer applied to an LCD with arc-shaped display edge. The color edge comprises a color filter area which comprises an edge display area close to the arc-shaped display edge; the edge display area comprises at least one first pixel block, areas of photo-permeable parts of sub-pixel units of the first pixel block are the same and the photo-permeable parts are arranged in a terraced manner along the arc-shaped display edge.

### SUMMARY

This invention provides a special-shaped display panel, and a display apparatus, aiming to solve the issue of appearance of zigzag, and of the color difference among pixels, at the edge of display panels.

In an aspect, the invention provides a special-shaped display panel according to appended independent claim 1.

Preferred embodiments of the special-shaped display panel are defined in the appended dependent claims 2-12.

In yet another aspect, the invention provides a display apparatus according to appended dependent claim 13

Other embodiments and implementations may become apparent in view of the following description and drawings.

### BRIEF DESCRIPTION OF DRAWINGS

To more clearly illustrate some of the embodiments, the following is a brief description of the drawings. The drawings in the following descriptions are only illustrative of some embodiments. For those of ordinary skill in the art, other drawings of other embodiments can become apparent based on these drawings.
FIG. 1 is a schematic diagram of a conventional special-shaped display panel.
FIG. 2 is a schematic diagram of a special-shaped display panel according to an example helpful to understand the claimed invention
FIG. 3 is a schematic diagram of a protruding region formed by a same row of multiple consecutively aligned edge pixel units in a conventional special-shaped display panel.
FIG. 4 is a schematic diagram of a protruding region after improvement over the protruding region as shown in FIG. 3 by means of a an exampled not according to the claimed invention.
FIG. 5 is a schematic diagram of a protruding region after improvement over the protruding region as shown in FIG. 3 by means of an embodiment of the invention.
FIG. 6 is a schematic diagram of a protruding region after improvement over the protruding region as shown in FIG. 3 by means of an embodiment of the invention.
FIG. 7 is a schematic diagram of a protruding region formed by a same column of multiple consecutively aligned edge pixel units in a conventional special-shaped display panel.
FIG. 8 is a schematic diagram of a protruding region after improvement over the protruding region as shown in FIG. 7 by means of a another example not covered by the claimed invention
FIG. 9 is a schematic diagram of a protruding region after improvement over the protruding region as shown in FIG. 7 by means of an embodiment of the invention.
FIG. 10 is a schematic diagram of a protruding region after improvement over the protruding region as shown in FIG. 7 by means of an embodiment of the invention.

### DETAILED DESCRIPTION

In the following, with reference to the drawings of various embodiments disclosed herein, the technical solutions of the embodiments of the disclosure will be described in a clear and fully understandable way. It is noted that the described embodiments are merely a portion but not all of the embodiments of the disclosure. Based on the described embodiments of the disclosure, those ordinarily skilled in the art can obtain other embodiment(s), which come(s) within the scope sought for protection defined by the appended claims .

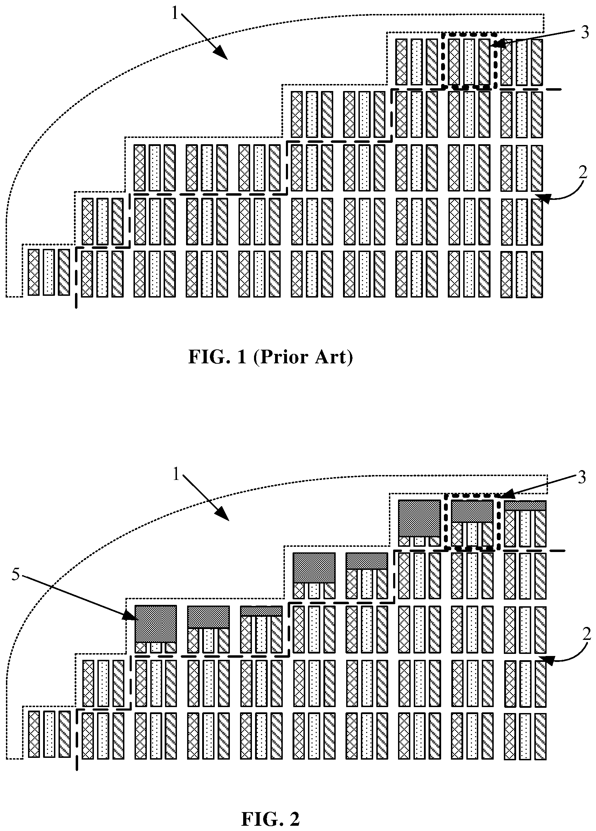

FIG. 1 is the schematic diagram of a conventional special-shaped display panel. As shown in FIG. 1, the display panel comprises a display region 2 and a light shielding region 1, arranged at the periphery of the display area 2. The display region 2 is provided with a pixel unit array comprising a plurality of pixel units. The outermost pixel units of the pixel unit array that are also adjacent to the light-shielding region 1 are edge pixel units 3.

In conventional pixel units, pixels are typically rectangular in shape, and thus in forming the edge of a special-shaped (with curved or oblique edge) display panel, the pixels of a same size in edge pixel units need to be arranged in a zigzag. When displaying, a difference in brightness exists between these edge pixel units and the light shielding region, which causes the edge of the display panel to exhibit a zigzag pattern.

Especially for multiple consecutive edge pixel units aligned in a same row or a same column, a ladder-shape appearance typically shows up between the row/column of pixel units and adjacent row/column of pixel units, i.e. a zigzag edge exhibits on the display panel, thereby resulting in a reduced visual effect on the edge of the display panel, and seriously influencing the user experience.

To solve this issue, this disclosure provides a display substrate. The display substrate includes a display region, which has an irregular edge portion including a plurality of edge pixel units. The plurality of edge pixel units have gradually varying light transmission rates along the edge portion to thereby reduce the zigzag pattern. To this end, the open ratios of the edge pixel units at the irregular edge portion of the display region can be altered, or alternatively each of the edge pixel units may be configured to have varying light transmission rate by itself while remaining a same open ratio. In this disclosure, it is mainly realized by altering the open ratios of the edge pixel units.

In some embodiments, the display region is provided with a pixel unit array, comprising a plurality of pixel units arranged in rows and columns, wherein each pixel unit comprises at least one pixel. The irregular edge portion of the display region comprises at least one protruding region, each of the at least one protruding region comprising a second plurality of edge pixel units. The second plurality of edge pixel units are consecutively aligned in a same row or a same column of the pixel unit array, and have gradually varying light transmission rates along the each of the at least one protruding region to thereby reduce a zigzag pattern.

FIG. 2 is a schematic diagram of a special-shaped display panel according to an exampled not falling under the claimed invention. As shown in FIG. 2, the display panel comprises a display region 2 and a light-shielding region 1, wherein the light-shielding region 1 is at the periphery of the display region 2. The display region 2 is provided with a pixel unit array, which comprises a plurality of pixel units. The pixel units at the outermost of the pixel unit array that are adjacent to the light-shielding region 1 are edge pixel units 3.

A plurality of consecutive edge pixel units aligned at a same row or at a same column form a protruding region; a protruding step forms at the intersection between a protruding region and the light-shielding region 1; the protruding region comprises a first light-shielding pattern 5, configured such that at least two transition sub-steps are formed at the intersection between the light-emitting sub-region of the protruding region and the first light-shielding pattern 5. The at least two transition sub-steps and the corresponding protruding step have a substantially same ascending direction.

It is noted that a step corresponds to a folded segment, which has only one turning point, and includes at least one horizontal segment or a longitudinal segment. The ascending direction in the disclosure can specifically include two scenarios, i.e. a first ascending direction and a second ascending direction, wherein the first ascending direction includes any direction between a first horizontal direction and a vertical upward direction, and the second ascending direction includes any direction between a second horizontal direction and a vertical upward direction.

In current technologies, the plurality of consecutive edge pixel units aligned at a same row or at a same column typically form a protruding step with a relatively big size, which easily results in the appearance of zigzags. In the example shown in Fig.2, by arranging a first light-shielding pattern 5 in the protruding region, the relatively big protruding step is transformed into multiple relatively small transition sub-steps having a substantially same ascending direction as the protruding step. These relatively small transition sub-steps result in less apparent zigzags, which in turn weakens the overall appearance of zigzags at the protruding region while displaying, ultimately leading to an improved visual effect at the edge of the display panel.

For convenience, a first ascending direction is the leftward ascending direction (i.e. pointing to upper left) in figures, and a second ascending direction is the rightward ascending direction (i.e. pointing to upper right) in the figures.

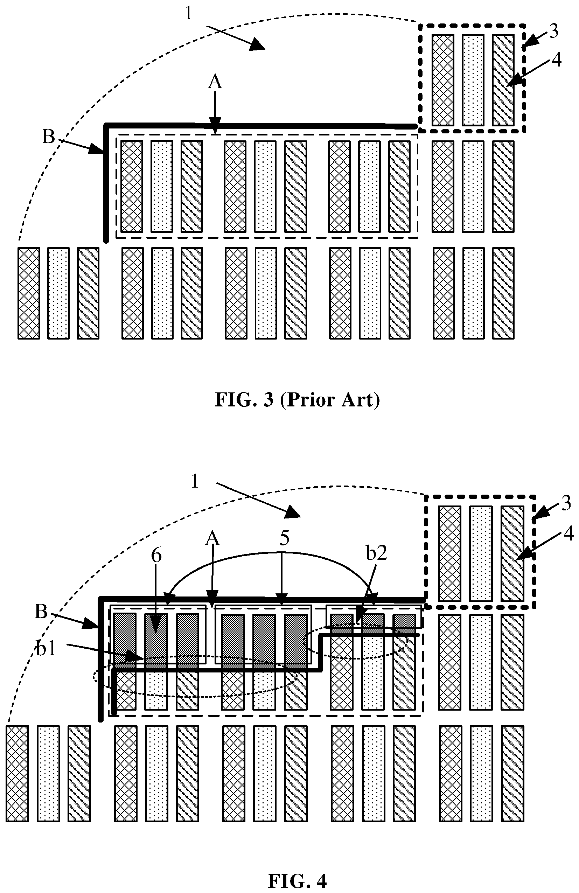

FIG. 3 is a schematic diagram of a protruding region formed by a same row of multiple consecutively aligned edge pixel units in conventional special-shaped display panels. As shown in FIG. 3, the three consecutive edge pixel units aligned at a same row form a protruding region A; a protruding step B is formed between the protruding region A and the light-shielding region 1; and the protruding step B has a rightward ascending direction.

FIG. 4 is a schematic diagram of a protruding region after improvement over the protruding region as shown in FIG. 3 by means of an exampled not falling under the claimed invention. As shown in FIG. 4, by arranging a first light-shielding pattern 5 in the protruding region A, two transition sub-steps b1 and b2 are formed at the intersection between the light-emitting sub-region of the protruding region A and the first light-shielding pattern 5; and the two transition sub-steps b1 and b2 both have a rightward ascending direction.

Compared with the protruding step B, the two transition sub-steps b1 and b2 are relatively smaller in size and are thus less obvious. Additionally because the two transition sub-steps b1 and b2 both have right ascending directions, the transition among different sub-steps appear relatively smooth, and the overall appearance of zigzags at the protruding region are thus weakened, which ultimately leads to an improved visual effect at the protruding region A. Consequently for the overall display panel, the visual effect at the edge of the display panel is improved.

Optionally the first light-shielding pattern 5 can include a plurality of light-shielding sub-patterns 6, which correspond to the pixels 4 included in each of the edge pixel units 3 in a one-to-one relationship and are configured to define the light-emitting sub-region of the corresponding pixels 4.

When the first light-shielding pattern 5 is configured to shield the edge pixel units 3, the pixels 4 in the edge pixel units 3 can optionally be configured to have a same area of light-emitting sub-region, thereby effectively avoiding the issue of color difference among different edge pixel units.

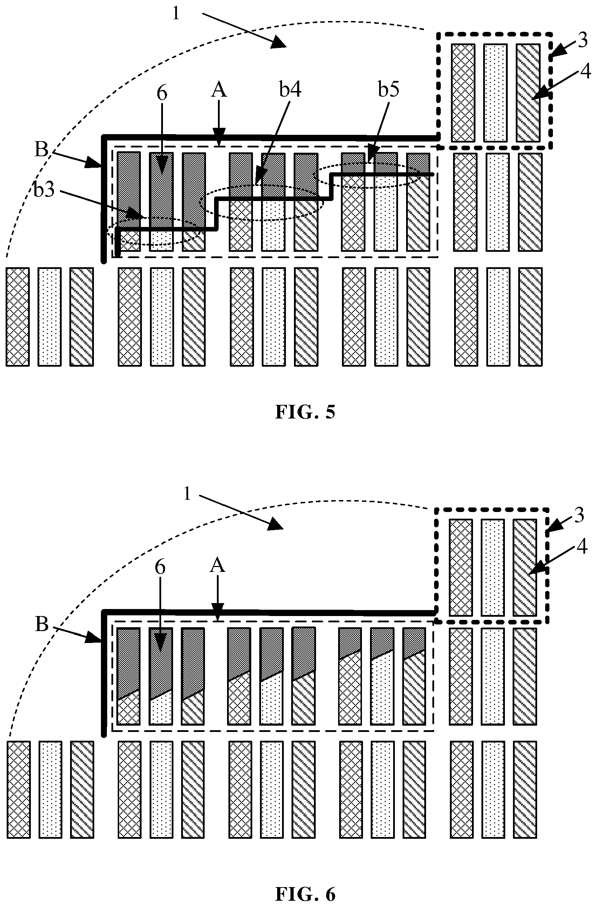

FIG. 5 is a schematic diagram of a protruding region after improvement over the protruding region as shown in FIG. 3 by means of a first embodiment of the invention . Compared with the example as shown in FIG. 4, transition sub-steps b3, b4 and b5 are configured to have a same number as edge pixel units 3 in the protruding region A, and to correspond to the edge pixel units in a one-to-one relationship, as shown in FIG. 5.

By this configuration, the transition sub-steps b3, b4, and b5 in the protruding region A have an even smaller size, thus resulting in a further weakened appearance of zigzags for the transition sub-steps and an improved visual effect at the protruding region A, ultimately leading to a further improved visual effect at the edge of the display panel.

The light-emitting sub-region of any two neighboring edge pixel units 3 in the protruding region are configured to have a same area difference, which can result in a smoothened transition among neighboring sub-steps in the protruding region. It is noted that the light-emitting sub-region of individual edge pixel unit 3 in the protruding region can be adjusted depending on the edge of the display panel.

FIG. 6 is a schematic diagram of a protruding region after improvement over the protruding region as shown in FIG. 3 by means of another embodiment of the invention. Compared with the first example and the first embodiment as respectively shown in FIGS. 4 and 5, whose pixels 4 included in each edge pixel unit in the protruding region both have a rectangular light-emitting sub-region, the pixels 4 included in each edge pixel unit in a protruding region can have a light-emitting sub-region shaped as a right trapezoid, as shown in FIG. 6.

Specifically, as shown in FIG. 6, each sub-pixel 4 has a rectangular shape, and the light-shielding sub-pattern 6 has a shape of a right trapezoid, whose right angle leg aligns with the side of the sub-pixel 4 that is next to the light-shielding region 1, whose slanted leg is parallel with a straight line running across the two ends of the protruding step.

In this embodiment, because the light-shielding sub-pattern 6 is configured to be shaped as a right trapezoid, the light-emitting sub-region of individual sub-pixel 4 also takes a shape of a right trapezoid, which can effectively weaken the appearance of zigzags among the transition sub-steps, causing a more smoothened transition between neighboring sub-steps, ultimately leading to an improved visual effect in the protruding region.

It is noted that the embodiment as shown in FIG. 6, where each of the light-shielding sub-patterns 6 is shaped as a right trapezoid so as to allow its intersection line with its corresponding sub-pixel (i.e. slanted leg) to be parallel with a straight line running across the two sides of the protruding step, represents one preferred embodiment of this disclosure. In some other embodiments, it is only required that the intersection line between the light-shielding sub-pattern and its corresponding pixel has a substantially same ascending direction as the protruding step, which shall be able to weaken or reduce the appearance of zigzags to some extent. The intersection line can be a concave arc or a convex arc.

In some embodiments, the light-shielding region 1 can optionally comprise a second light-shielding pattern (not shown in figures), which is disposed in a same layer along as the first light-shielding pattern 5. The second light-shielding pattern can be made by a conventional display substrate fabrication process, which requires modification of the masks for making the second light-shielding pattern.

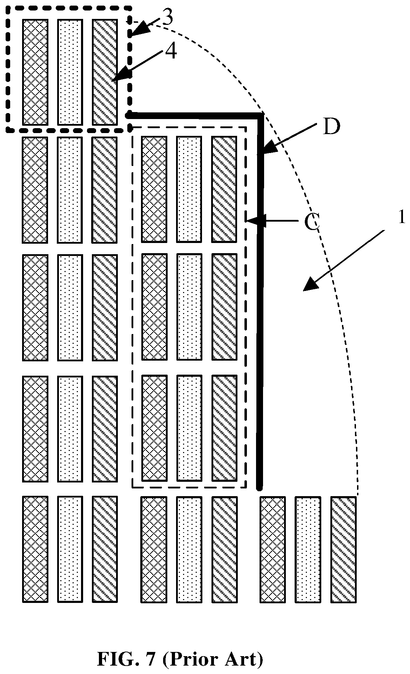

FIG. 7 is a schematic diagram of a protruding region formed by a same column of multiple consecutively aligned edge pixel units in a conventional special-shaped display panel. As shown in FIG. 7, the three consecutive edge pixel units aligned in a same column form a protruding region C; a protruding step D is formed at the intersection between the light-shielding region 1 and the protruding region C; and the protruding step D has a leftward ascending direction.

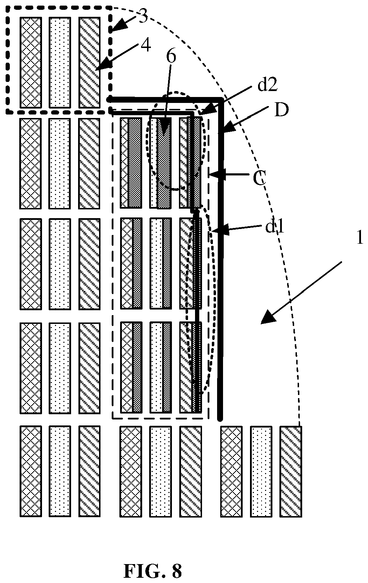

FIG. 8 is a schematic diagram of a protruding region after improvement over the protruding region as shown in FIG. 7 by means of an example not according to claimed invention As shown in FIG. 7, by arranging a first light-shielding pattern 5 in the protruding region C , two transition sub-steps d1 and d2 are formed at the intersection between the light-emitting sub-region of the protruding region C and the first light-shielding pattern 5; and the two transition sub-steps b1 and b2 both have a leftward ascending direction.

Compared with the protruding step D, the two transition sub-steps d1 and d2 are relatively smaller in size and are thus less obvious. Additionally because the two transition sub-steps d1 and d2 both have leftward ascending directions, the transition among different sub-steps appears relatively smooth, and the overall appearance of zigzags at the protruding region C is thus weakened, which ultimately leads to an improved visual effect at the protruding region C. Consequently for the overall display panel, the visual effect at the edge of the display panel is improved.

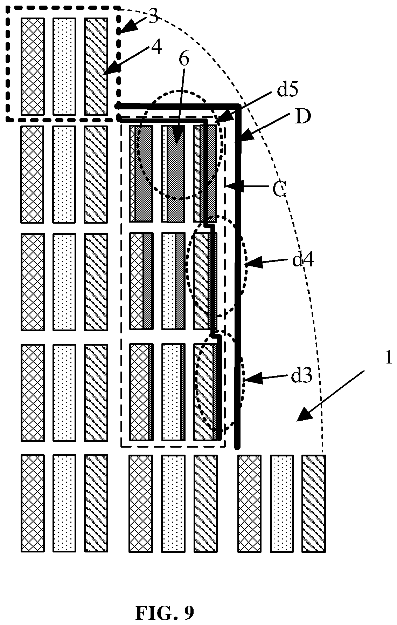

FIG. 9 is a schematic diagram of a protruding region after improvement over the protruding region as shown in FIG. 7 by means of another embodiment of the invention As shown in FIG. 9, the transition sub-steps d3, d4 and d5 are configured to have a same number as the edge pixel units 3 in the protruding region C, and to correspond to the edge pixel units 3 in a one-to-one relationship. By this configuration, the transition sub-steps d3, d4, and d5 in the protruding region C have an smaller size, thus resulting in a further weakened appearance of zigzags for the transition sub-steps and an improved visual effect at the protruding region C, ultimately leading to a further improved visual effect at the edge of the display panel.

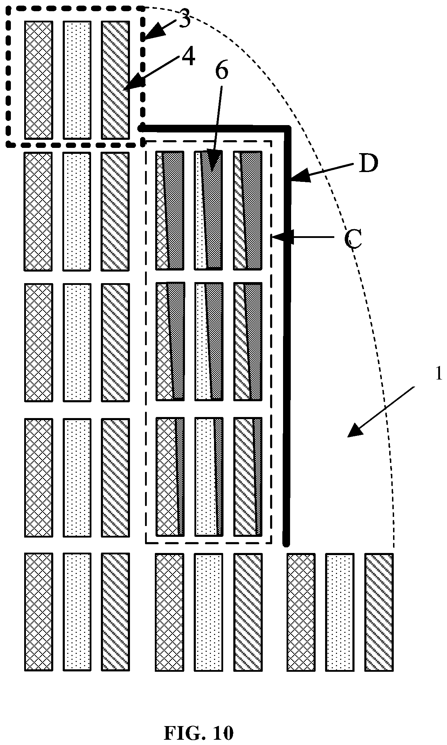

FIG. 10 is a schematic diagram of a protruding region after improvement over the protruding region as shown in FIG. 7 by means of another embodiment of the invention. As shown in FIG. 10, each of the pixels 4 included in an edge pixel unit 3 in the protruding region C has a light-emitting sub-region shaped as a right trapezoid. Specifically, each sub-pixel 4 has a rectangular shape, and the light-shielding sub-pattern 6 has a shape of a right trapezoid, whose right angle leg aligns with the side of the sub-pixel 4 that is next to the light-shielding region 1, whose slanted leg is parallel with a straight line running across the two sides of the protruding step.

In this embodiment, because the light-shielding sub-pattern 6 is configured to be shaped as a right trapezoid, the light-emitting sub-region in individual sub-pixel 4 also takes a shape of a right trapezoid, which can effectively weaken the appearance of zigzags among the transition sub-steps, resulting in a more smoothened transition among neighboring sub-steps and ultimately leading to an improved visual effect in the protruding region.

It is noted that in order to avoid the issue of color difference among different edge pixel units, the pixels 4 in each individual edge pixel unit 3 can each be configured to have a same area for the light-emitting sub-region.

The embodiments as described above can effectively weaken the appearance of zigzags in both the horizontal protruding regions (comprising multiple consecutively aligned edge pixel units on same rows) and the longitudinal protruding regions (comprising multiple consecutively aligned edge pixel units on same columns), leading to an improved visual effect at the edge of display panels.

It is noted that the above embodiments, where the protruding region comprises three edge pixel units 3, are only for illustration and shall not limit the scope of the disclosure. The number of edge pixel units 3 in a protruding region can be an integer > 1.

The display substrate can be a color film substrate in some embodiments, a color filter on array (COA) substrate in some other embodiments, or an organic light emitting display (OLED) substrate in yet some other embodiments. The first light-shielding pattern and the second light-shielding pattern can be disposed at a same layer as the black matrix (BM) in the substrate of the color film substrate or the color filter on array (COA) substrate.

In another aspect, the invention also provides a display apparatus, which includes the display panel as described above.

Although specific embodiments have been described above in detail, the description is merely for purposes of illustration. It should be appreciated, therefore, that many aspects described above are not intended as required or essential elements unless explicitly stated otherwise. Various modifications of the disclosed aspects of the exemplary embodiments, in addition to those described above, can be made by a person of ordinary skill in the art, that would fall within the scope of the appended claims.

## Claims

1. A special-shaped display panel with a curved or oblique edge, the special-shaped display panel including a display substrate, the display substrate comprising a display region (2) in which a pixel unit array is provided and a light-shielding region (1) at periphery of the display region (2), wherein:
the pixel unit array comprises a plurality of pixel units (3) arranged in rows and columns;
the display region (2) has an irregular edge portion along the curved or oblique edge of the display panel, the irregular edge portion including a plurality of edge pixel units (3) arranged adjacent to the light-shielding region (1);
the irregular edge portion of the display region (2) comprises at least one protruding region (A), each of the at least one protruding region (A) comprising a plurality of consecutive edge pixel units (3) aligned in a same row or a same column and forming a protruding step with respect to a directly adjacent row or column of pixel units, the plurality of edge pixel units (3) of each protruding region (A) having gradually varying light transmission rates along the protruding region (1);
each pixel unit (3) and each edge pixel unit (3) comprise a plurality of pixels (4), respectively; **characterised in that** any two neighboring edge pixel units (3) in each of the at least one protruding region (A) have a substantially same difference in light-emitting area.

2. The special-shaped display panel of Claim 1, wherein each protruding region (A) comprises at least one light-shielding pattern, the at least one light-shielding pattern comprises a first light-shielding pattern (5), the first light-shielding pattern (5) comprises a plurality of light-shielding sub-patterns (6) corresponding to the pixels (4) in each of the plurality of edge pixel units (3) in a one-to-one relationship, and the first light-shielding pattern (5) is arranged in each of the at least one protruding region (A) to make the plurality of edge pixel units (3) thereof have gradually varying opening ratios resulting in the gradually varying light transmission rates along each of the at least one protruding region (A).

3. The special-shaped display panel of Claim 2, wherein the opening ratios for different pixels (4) of different colors are substantially same within each of the plurality of edge pixel unit (3) in the each of the at least one protruding region (A).

4. The special-shaped display panel of Claim 2, wherein the gradually varying opening ratios for the plurality of edge pixel units (3) in the each of the at least one protruding region (A) is realized by configuring at least two transition sub-steps (b3, b4, b5) between a light-emitting sub-region of the each of the at least one protruding region (A) and the light-shielding region (1), wherein the at least two transition sub-steps (b3, b4, b5) each has a substantially same ascending direction as a protruding step (B) formed between the each of the at least one protruding region (A) and the light-shielding region (1).

5. The special-shaped display panel of Claim 4, wherein the at least one light-shielding pattern is disposed over each of the at least one protruding region (A) and configured to form the at least two transition sub-steps (b3, b4, b5) in the each of the at least one protruding region (A).

6. The special-shaped display panel of Claim 5, wherein the plurality of edge pixel units (3) in each of the at least one protruding region (A) correspond to the at least two transition sub-steps (b3, b4, b5) in a one-to-one relationship.

7. The special-shaped display panel of Claim 5, wherein the at least one light-shielding pattern further comprises a second light-shielding pattern, and the first and second light-shielding patterns are in a same layer.

8. The special-shaped display panel of Claim 2 , wherein each pixel (4) has a rectangular shape, and each of the plurality of light-shielding sub-patterns (6) is rectangular.

9. The special-shaped display panel of Claim 2 , wherein an intersection line between each of the plurality of light-shielding sub-patterns (6) and corresponding light-emitting sub-region has a substantially same ascending direction as the protruding step (B);

10. The special-shaped display panel of Claim 9, wherein each of the intersection lines between the plurality of light-shielding sub-patterns (6) and corresponding light-emitting sub-regions is a straight line or a curved line.

11. The special-shaped display panel according to any of Claims 1- 10 , wherein the display substrate is a color film substrate, a color filter on array substrate, or an OLED substrate.

12. The special-shaped display panel according to any of Claims 2-10 , wherein the at least one light-shielding pattern is at a same layer as a black matrix in the color film substrate or the color filter on array substrate.

13. A display apparatus, comprising the special-shaped display panel according to any of Claims 1-12.

## Patentansprüche

1. Speziell geformte Anzeigetafel mit einem gekrümmten oder schrägen Rand, wobei die speziell geformte Anzeigetafel ein Anzeigesubstrat enthält, wobei das Anzeigesubstrat einen Anzeigebereich (2), in dem ein Pixeleinheiten-Array vorgesehen ist, und einen lichtabschirmenden Bereich (1) an der Peripherie des Anzeigebereichs (2) aufweist, wobei:
das Pixeleinheiten-Array mehrere Pixeleinheiten (3) aufweist, die in Zeilen und Spalten angeordnet sind;
der Anzeigebereich (2) einen unregelmäßigen Randabschnitt entlang des gekrümmten oder schrägen Randes der Anzeigetafel hat, wobei der unregelmäßige Randabschnitt mehrere Randpixeleinheiten (3) aufweist, die benachbart zu dem lichtabschirmenden Bereich (1) angeordnet sind;
der unregelmäßige Randabschnitt des Anzeigebereichs (2) mindestens einen vorstehenden Bereich (A) aufweist, wobei jeder des mindestens einen vorstehenden Bereichs (A) mehrere aufeinanderfolgende Randpixeleinheiten (3) aufweist, die in einer gleichen Zeile oder einer gleichen Spalte ausgerichtet sind und in Bezug auf eine unmittelbar benachbarte Zeile oder Spalte von Pixeleinheiten eine vorstehende Stufe bilden,
wobei die mehreren Randpixeleinheiten (3) jedes vorstehenden Bereichs (A) sich allmählich ändernde Lichtdurchlässigkeitsraten entlang des vorstehenden Bereichs (1) haben;
jede Pixeleinheit (3) und jede Randpixeleinheit (3) jeweils mehrere Pixel (4) aufweist; **dadurch gekennzeichnet, dass**
zwei beliebige benachbarte Randpixeleinheiten (3) in jedem der mindestens einen vorstehenden Bereiche (A) einen im Wesentlichen gleichen Unterschied in der lichtemittierenden Fläche aufweisen.

2. Speziell geformte Anzeigetafel nach Anspruch 1, wobei jeder vorstehende Bereich (A) mindestens ein lichtabschirmendes Muster aufweist, wobei das mindestens eine lichtabschirmende Muster ein erstes lichtabschirmendes Muster (5) aufweist, wobei das erste lichtabschirmende Muster (5) mehrere lichtabschirmende Teilmuster (6) aufweist, die den Pixeln (4) in jeder der mehreren Randpixeleinheiten (3) in einer Eins-zu-Eins-Beziehung entsprechen, und das erste lichtabschirmende Muster (5) in jedem des mindestens einen vorstehenden Bereichs (A) angeordnet ist, um die mehreren Randpixeleinheiten (3) dort sich allmählich ändernde Öffnungsverhältnisse aufweisen zu lassen, so dass sich dadurch die sich allmählich ändernden Lichtdurchlässigkeitsraten entlang jedes des mindestens einen vorstehenden Bereichs (A) ergeben.

3. Speziell geformte Anzeigetafel nach Anspruch 2, wobei die Öffnungsverhältnisse für verschiedene Pixel (4) verschiedener Farben innerhalb jeder der mehreren Randpixeleinheiten (3) in jedem des mindestens einen vorstehenden Bereichs (A) im Wesentlichen gleich sind.

4. Speziell geformte Anzeigetafel nach Anspruch 2, wobei die sich allmählich ändernden Öffnungsverhältnisse für die mehreren Randpixeleinheiten (3) in jedem des mindestens einen vorstehenden Bereichs (A) durch Konfigurieren von mindestens zwei Übergangs-Teilstufen (b3, b4, b5) zwischen einem lichtemittierenden Teilbereich jedes des mindestens einen vorstehenden Bereichs (A) und dem lichtabschirmenden Bereich (1) realisiert werden, wobei die mindestens zwei Übergangs-Teilstufen (b3, b4, b5) jeweils eine im Wesentlichen gleiche ansteigende Richtung wie eine vorstehende Stufe (B) haben, die zwischen jedem des mindestens einen vorstehenden Bereichs (A) und dem lichtabschirmenden Bereich (1) gebildet ist.

5. Speziell geformte Anzeigetafel nach Anspruch 4, wobei das mindestens eine lichtabschirmende Muster über jedem des mindestens einen vorstehenden Bereichs (A) angeordnet ist und konfiguriert ist, um die mindestens zwei Übergangs-Teilstufen (b3, b4, b5) in jedem des mindestens einen vorstehenden Bereichs (A) zu bilden.

6. Speziell geformte Anzeigetafel nach Anspruch 5, wobei die mehreren Randpixeleinheiten (3) in jedem des mindestens einen vorstehenden Bereichs (A) den mindestens zwei Übergangs-Teilstufen (b3, b4, b5) in einer Eins-zu-Eins-Beziehung entsprechen.

7. Speziell geformte Anzeigetafel nach Anspruch 5, wobei das mindestens eine lichtabschirmende Muster ferner ein zweites lichtabschirmendes Muster aufweist und das erste und das zweite lichtabschirmende Muster in einer gleichen Schicht liegen.

8. Speziell geformte Anzeigetafel nach Anspruch 2, wobei jedes Pixel (4) eine rechteckige Gestalt hat und jedes der mehreren lichtabschirmenden Teilmuster (6) rechteckig ist.

9. Speziell geformte Anzeigetafel nach Anspruch 2, wobei eine Schnittlinie zwischen jedem der mehreren lichtabschirmenden Teilmuster (6) und dem entsprechenden lichtemittierenden Teilbereich eine im Wesentlichen gleiche ansteigende Richtung wie die vorstehende Stufe (B) hat.

10. Speziell geformte Anzeigetafel nach Anspruch 9, wobei jede der Schnittlinien zwischen den mehreren lichtabschirmenden Teilmustern (6) und entsprechenden lichtemittierenden Teilbereichen eine gerade Linie oder eine gekrümmte Linie ist.

11. Speziell geformte Anzeigetafel nach einem der Ansprüche 1 bis 10, wobei das Anzeigesubstrat ein Farbfilmsubstrat, ein Farbfiltersubstrat auf einem Array oder ein OLED-Substrat ist.

12. Speziell geformte Anzeigetafel nach einem der Ansprüche 2 bis 10, wobei sich das mindestens eine lichtabschirmende Muster auf einer gleichen Schicht wie eine schwarze Matrix in dem Farbfilmsubstrat oder dem Farbfilter auf dem Arraysubstrat befindet.

13. Anzeigevorrichtung, die speziell geformte Anzeigetafel nach einem der Ansprüche 1 bis 12 aufweisend.

## Revendications

1. Panneau d'affichage de forme spéciale avec un bord incurvé ou oblique, le panneau d'affichage de forme spéciale comprenant un substrat d'affichage, le substrat d'affichage comprenant une région d'affichage (2) dans laquelle une matrice d'unités de pixels est prévue ainsi qu'une région faisant écran à la lumière (1) à la périphérie de la région d'affichage (2), dans lequel :
la matrice d'unités de pixels comprend une pluralité d'unités de pixels (3) disposées en rangées et en colonnes ;
la région d'affichage (2) a une partie de bord irrégulier le long du bord incurvé ou oblique du panneau d'affichage, la partie de bord irrégulier comprenant une pluralité d'unités de pixels de bord (3) agencées adjacentes à la région faisant écran à la lumière (1) ;
la partie de bord irrégulier de la région d'affichage (2) comprend au moins une région en saillie (A), chacune desdites au moins une région en saillie (A) comprenant une pluralité d'unités de pixel de bord (3) consécutives alignées dans une même rangée ou une même colonne et formant un étage en saillie par rapport à une rangée ou colonne directement adjacente d'unités de pixels,
la pluralité d'unités de pixel de bord (3) de chaque région en saillie (A) ayant des vitesses de transmission de lumière variant graduellement le long de la région en saillie (1) ;
chaque unité de pixel (3) et chaque unité de pixel de bord (3) comprennent une pluralité de pixels (4), respectivement ; **caractérisé en ce que** deux unités de pixel de bord (3) voisines dans chacune desdites au moins une région en saillie (A) ont une différence sensiblement identique dans la zone d'émission de lumière.

2. Panneau d'affichage de forme spéciale selon la revendication 1, dans lequel chaque région en saillie (A) comprend au moins un motif faisant écran à la lumière, lesdits au moins un motif faisant écran à la lumière comprennent un premier motif faisant écran à la lumière (5), le premier motif faisant écran à la lumière (5) comprend une pluralité de sous-motifs faisant écran à la lumière (6) correspondant aux pixels (4) dans chaque unité de la pluralité d'unités de pixels de bord (3) dans une relation un à un, et le premier motif faisant écran à la lumière (5) est agencé dans chacune desdites au moins une région en saillie (A) pour faire en sorte que la pluralité d'unités de pixels de bord (3) de celle-ci aient des rapports d'ouverture variant graduellement résultant en des vitesses de transmission de lumière variant graduellement le long de chacune desdites au moins une région en saillie (A).

3. Panneau d'affichage de forme spéciale selon la revendication 2,
dans lequel les rapports d'ouverture pour différents pixels (4) de différentes couleurs sont sensiblement les mêmes dans chaque unité de la pluralité d'unités de pixels de bord (3) dans chacune desdites au moins une région en saillie (A).

4. Panneau d'affichage de forme spéciale selon la revendication 2,
dans lequel les rapports d'ouverture variant progressivement pour la pluralité d'unités de pixels de bord (3) dans chacune desdites au moins une région en saillie (A) sont réalisés en configurant au moins deux sous-étages de transition (b3, b4, b5) entre une sous-région émettrice de lumière de chacune desdites au moins une région en saillie (A) et la région faisant écran à la lumière (1),
dans lequel lesdits au moins deux sous-étages de transition (b3, b4, b5) ont chacun sensiblement la même direction ascendante qu'un étage en saillie (B) formé entre chacune desdites au moins une région en saillie (A) et la région faisant écran à la lumière (1).

5. Panneau d'affichage de forme spéciale selon la revendication 4, dans lequel lesdits au moins un motif faisant écran à la lumière sont disposés sur chacune desdites au moins une région en saillie (A) et configurés pour former lesdits au moins deux sous-étages de transition (b3, b4, b5) dans chacune desdites au moins une région en saillie (A).

6. Panneau d'affichage de forme spéciale selon la revendication 5, dans lequel la pluralité d'unités de pixel de bord (3) dans chacune desdites au moins une région en saillie (A) correspond auxdits au moins deux sous-étages de transition (b3, b4, b5) dans une relation un à un.

7. Panneau d'affichage de forme spéciale selon la revendication 5, dans lequel lesdits au moins un motif faisant écran à la lumière comprennent en outre un second motif faisant écran à la lumière, et les premier et second motifs faisant écran à la lumière sont dans une même couche.

8. Panneau d'affichage de forme spéciale selon la revendication 2, dans lequel chaque pixel (4) a une forme rectangulaire, et chaque sous-motif de la pluralité de sous-motifs faisant écran à la lumière (6) est rectangulaire.

9. Panneau d'affichage de forme spéciale selon la revendication 2, dans lequel une ligne d'intersection entre chaque sous-motif de la pluralité de sous-motifs faisant écran à la lumière (6) et la sous-région émettrice de lumière correspondante a sensiblement la même direction ascendante que l'étage en saillie (B) ;

10. Panneau d'affichage de forme spéciale selon la revendication 9,
dans lequel chacune des lignes d'intersection entre la pluralité de sous-motifs faisant écran à la lumière (6) et les sous-régions émettrices de lumière correspondantes est une ligne droite ou une ligne courbe.

11. Panneau d'affichage de forme spéciale selon l'une quelconque des revendications 1 à 10, dans lequel le substrat d'affichage est un substrat de film de couleur, un filtre de couleur sur un substrat de matrice ou un substrat OLED.

12. Panneau d'affichage de forme spéciale selon l'une quelconque des revendications 2 à 10, dans lequel lesdits au moins un motif faisant écran à la lumière sont au niveau d'une même couche qu'une matrice noire dans le substrat de film de couleur ou le filtre de couleur sur le substrat de matrice.

13. Appareil d'affichage, comprenant le panneau d'affichage de forme spéciale selon l'une quelconque des revendications 1 à 12.
